# EUROPÄISCHE PATENTANMELDUNG

(11) **EP 1 217 739 A1**
(43) Veröffentlichungstag der Anmeldung: **26.06.2002**
(21) Anmeldenummer: 01130455.7
(22) Anmeldetag: 20.12.2001
(51) Int. Cl.: H03J 7/04

(54) **Relais Transceiver**

(30) Priorität: 23.12.2000 DE 10065159
(71) Anmelder: harris Communications Austria GmbH, 1010 Wien (AT)
(72) Erfinder: Hauck, Walter, 6850 Dornbirn (AT)
(74) Vertreter: Fleuchaus, Leo, Dipl.-Ing.

(57) **Zusammenfassung**

Die Erfindung betrifft einen Schaltungsteil (Muttersenderanbindung) in der Frequenzaufbereitung eines TV-Umsetzers, bei dem es sich in der Praxis gezeigt hat, daß aufgrund der Signalübertragung in der Luft Mehrwegeempfang entstehen kann. Daraus ergibt sich das Problem, daß sich zeitweise eine Auslöschung ergibt, wobei durch die kurzzeitigen Signalaussetzer die Muttersenderanbindung gestört wird. Um diese kurze Zeitspanne zu überbrücken, wird nach dem Einrasten auf einen Schwingkreis mit hoher Güte umgeschaltet. Der Schwingkreis überbrückt die Zeit durch gedämpftes Ein- und Ausschwingen, wodurch immer ein Signal an dem Phasenregelkreis liegt.

## Beschreibung

Die Erfindung betrifft einen TV-Umsetzer gemäß den Merkmalen des jeweiligen Oberbegriffes der unabhängigen Patentansprüche.

Solche TV-Umsetzer werden von der Firma Hirschmann entwickelt und gefertigt und sind z.B. in dem Betriebshandbuch zu dem TV-Umsetzer TVU 606 beschrieben. In diesen TV-Umsetzern erfolgt eine Frequenzaufbereitung. Um die Auswirkung von Gleichkanalstörungen bei dichten Sendernetzen zu reduzieren, werden diese TV-Umsetzer mit einer Frequenzanbindung betrieben. Dazu werden alle intern erzeugten Frequenzen an eine Referenzfrequenz angebunden. Dabei stehen folgende Konfigurationen von Frequenzaufbereitungen zu Verfügung:
- interner Referenzoszillator,
- interne Frequenzanbindung,
- Leitfrequenzanbindung an externe Referenzfrequenz,
- Leitfrequenzanbindung an interne Referenzfrequenz oder
- Muttersenderanbindung.

Die Muttersenderanbindung bzw. Leitfrequenzanbindungen haben zwar den Vorteil, daß ein Nachgleichen der Umsetzer-Oszillatoren überflüssig ist. Bezüglich der verschiedenen Frequenzaufbereitungen wird auf den Seiten 2 - 8 bis 2 - 12 des genannten Benutzerhandbuches verwiesen.

In der Praxis hat sich nun herausgestellt, daß aufgrund der Signalübertragung in der Luft Mehrwegeempfang entstehen kann. Daraus ergibt sich das Problem, daß beim Empfängereingang am TV-Umsetzer ein resultierendes Signal anliegt, das zeitweise eine Auslöschung ergibt oder auch ein Signal entstehen kann, das eine entgegengesetzte Phasenlage aufweist. Dadurch kann es bei der bekannten Muttersenderanbindung zum Ausrasten des Phasenregelkreises kommen, so daß der TV-Umsetzer kurzzeitig abgeschaltet wird, weil die Abstrahlung einer falschen Frequenz zu vermeiden ist. Das eigentliche Fernsehsignal wird gestört oder weist Aussetzer auf. Dies macht sich für den Betrachter des Fernsehbildes durch Störungen oder Ausfälle des Bildes bemerkbar.

Der Erfindung liegt daher die Aufgabe zugrunde, einen TV-Umsetzer der eingangs genannten Art bereit zu stellen, mit dem die geschilderten Nachteile vermieden werden.

Diese Erfindung ist durch die Merkmale des jeweiligen unabhängigen Patentanspruches 1 bzw. 2 gelöst.

Erfindungsgemäß ist vorgesehen, daß die Signalverarbeitungsmittel einen Schalter aufweisen,
- mit dem ein weiterer Schwingkreis zugeschaltet wird bzw.
- mit dem auf einen weiteren Schwingkreis umgeschaltet werden kann.

### Dabei wird folgender Effekt ausgenutzt:

Die Eingangsfrequenz des TV-Umsetzer (Fernsehfrequenz-Umsetzer) wird mit Hilfe eines Phasenregelkreises (PLL) als Referenzfrequenz verwendet. Denkbar ist auch die Erzeugung einer eigenen Referenzfrequenz innerhalb des TV-Umsetzers. Durch das Zuschalten oder das Umschalten auf einen weiteren Schwingkreis innerhalb der Signalverarbeitungsmittel, die auch den Phasenregelkreis aufweisen, wird der Effekt erzielt, daß der Schwingkreis eine gewisse Zeit durch ein gedämpftes Ein- und Ausschwingen überbrückt, so daß dadurch immer ein Signal an dem Phasenregelkreis anliegt. So kann ein Mehrwegeempfang bei der Übertragung des Fernsehsignales in der Luft, auch wenn dieses zeitweise eine Auslöschung enthält, nicht mehr zu einer Abschaltung des TV-Umsetzers infolge einer Störung des PLL durch Mehrwegempfang führen. Damit ist eine störungsfreie Signalumsetzung und damit einhergehend die störungsfreie Signalabgabe von dem TV-Umsetzers gewährleistet.

In vorteilhafter Weise weist der Schwingkreis eine hohe Güte auf, mit der das gedämpfte Ein- und Ausschwingen realisiert werden kann.

Die Muttersenderanbindung hat den Vorteil, daß ein alterungsbedingtes Nachgleichen der Oszillatoren des TV-Umsetzers nicht mehr erforderlich ist, weil es diese Oszillatoren nicht mehr gibt. Die Genauigkeit der Frequenz am Eingang wird somit an den Ausgang übertragen und bleibt erhalten.

Weitere Ausgestaltungen schaltungstechnischer Art sind in den Unteransprüchen angegeben, aus denen sich die entsprechenden Vorteile ergeben.

Die Realisierung eines erfindungsgemäßen TV-Umsetzers auf die die Erfindung jedoch nicht beschränkt ist, ist im folgenden im Vergleich mit dem Stand der Technik beschrieben und anhand der Figuren erläutert.

Es zeigen:
- Figur 1:: einen TV-Umsetzer gemäß dem Stand der Technik,
- Figur 2:: eine erfindungsgemäße Muttersenderanbindung als Teil eines TV-Umsetzers.

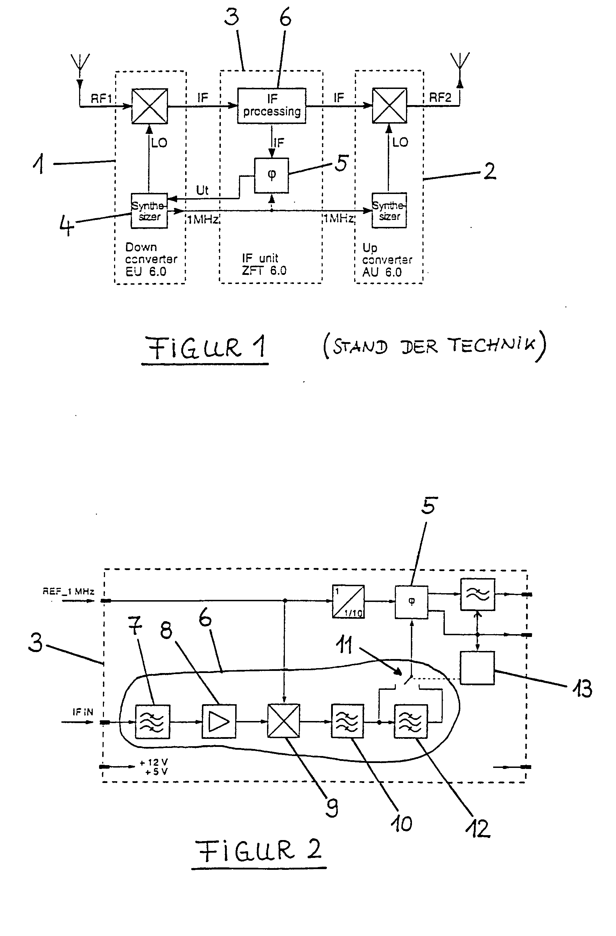

Figur 1 zeigt das Blockschaltbild eines TV-Umsetzers gemäß dem Stand der Technik, wobei in Figur 1 das Blockschaltbild der Muttersenderanbindung gezeigt ist. Eingangsseitig ist ein Eingangsumsetzer 1 vorgesehen, der über eine Antenne ein Eingangssignal RF1 empfängt. Ausgangsseitig ist ein Ausgangsumsetzer 2 vorhanden, der über eine Antenne ein Ausgangssignal RF 2 abstrahlt. Zwischen diesen beiden Umsetzern 1 und 2 ist eine Zwischenfrequenzeinheit 3 geschaltet, die in an sich bekannter Weise arbeitet. In dem Eingangsumsetzer 1 ist ein Synthesizer 4 vorhanden, der aus dem Eingangssignal RF1 ein Referenzsignal (z.B. 1 Megahertz) erzeugt. Dieses Referenz-
signal dient der Anbindung aller intern erzeugten Frequenzen an diese Referenzfrequenz zwecks Abgleiches. Unter anderem wird dieses Referenzsignal einem Phasenregelkreis 5 innerhalb der Zwischenfrequenzeinheit 3 zugeführt, der der Synchronisierung der intern erzeugten Frequenzen dient. Dazu erhält der Phasenregelkreis 5 auch ein Signal vom Signalverarbeitungsmittel 6 innerhalb der Zwischenfrequenzeinheit 3. Bei einer solchen Schaltung kann es vorkommen, daß aufgrund der Übertragung des Fernsehsignales in der Luft der Mehrwegeempfang entstehen kann, so daß eine zumindest zeitweise Auslöschung des Eingangssignales RF1 auch zu einer Auslöschung des_Ausgangssignales des Phasenregelkreises 5 führt und dadurch das Eingangssignal des Phasenregelkreises kurzzeitig fehlt, was zu einem kurzzeitigen Ausfall des Phasenregelkreises führt. Eine Auslöschung des Signals ergibt sich bereits, wenn durch die Verzögerung des reflektierten, um etwa 20 dB kleineren Signals, der Synchronimpuls des reflektierten Signals zeitlich in den Weißbereich des Bildes fällt (der Weißbereich entspricht jedenfalls 10% Restträger = -20 dB des Synchronwertes). Kommt es nicht unbedingt zu einer Auslöschung dieses Signals, so kann dort zumindest das Ausgangssignal (Synchronimpuls) in einen Signalbereich fallen, der ebenfalls die gleiche Wirkung hat. Bei diesem Bereich handelt es sich beispielsweise um ein Bild mit Weißwert, wobei der Weißwert etwa 10% des Restträgers entspricht.

Figur 2 zeigt eine erfindungsgemäße Muttersenderanbindung, mit der die schon beschriebenen Nachteile vermieden werden. Neben den schon in Figur 1 gezeigten und beschriebenen sowie mit gleichen Bezugsziffern versehenen Elementen sind in Figur 2 zunächst die Signalverarbeitungsmittel 6 detaillierter dargestellt. Das den Verarbeitungsmitteln 6 zugeführte Eingangssignal (Ifin) wird einem Eingangsschingkreis zugeführt, dessen Ausgangssignal einem Verstärker 8 sowie einem Mischer 9 zugeführt wird, wobei der Mischer 9 das intern oder extern erzeugte Referenzsignal sowie das aufbereitete Eingangssignal verarbeitet. Das Ausgangssignal des Mischer 9 wird einem Ausgangsschwingkreis 10 zugeführt, wobei die Änderung und Neuerung nun darin zu sehen ist, daß das Ausgangssignal des Ausgangsschwingkreises zunächst über einen Schalter 11 dem Phasenregelkreis 5 zugeführt werden kann. Durch Betätigung des Schalters 11 kann das Ausgangssignal des Ausgangsschwingkreises 10 aber auch über einen weiteren Schwingkreis 12 mit insbesonderer hoher Güte dem Phasenregelkreis 5 zugeführt werden. Dadurch wird, wie beschrieben, das Auslöschen von Signalen wirksam vermieden. Der Schalter 11 ist in besonders vorteilhafter Weise als elektronischer Schalter ausgebildet, da bei den verwendeten hohen Frequenzen ein mechanischer Schalter nicht unbedingt zuverlässig arbeiten würde. Die Betätigung des Schalters 11 erfolgt über ein Monoflop 13 mit einer vorgebbaren Abfallzeit, dem das Locked-Signal des Phasenregelkreises 5 zugeführt wird. Ist die komplette Frequenzaufbereitung des TV-Umsetzers gelockt, erfolgt eine Umschaltung auf den Schwingkreis 12 mit hoher Güte, und gleichzeitig wird das Schleifefilter auf niedrige Bandbreite umgeschaltet. Ab diesem Moment ist die Schaltung unempfindlich gegenüber Signaleinbrüche durch das gedämpfte Ein- und Ausschwingen des weiteren Schwingkreises 12. Eine Zeitüberbrückung erfolgt derart, daß immer ein Signal an dem Phasenregelkreis 5 anliegt. Das Monoflop sorgt für eine stabile Stellung des Schaltzustandes, dem das Ausgangssignal des Phasenregelkreises 5 zugeführt wird. Stellt das Monoflop 13 fest, daß ein Signal ausgefallen ist oder auch von einem vorgebbaren Sollwert abweicht, betätigt er den Schalter 11, so daß der weitere Schwingkreis 12 zugeschaltet wird. Durch das gedämpfte Ein- und Ausschwingen des weiteren Schwingkreises 12 (ggf. der beiden Schwingkreise 10 und 12) erfolgt eine Zeitüberbrückung derart, daß immer ein Signal an dem Phasenregelkreis 5 anliegt.

## Patentansprüche

1. TV-Umsetzer mit einem Eingangsumsetzer (1) und einem Ausgangsumsetzer (2), denen eine Zwischenfrequenzeinheit (3), die zumindest einen Phasenregelkreis (5) und Signalverarbeitungsmittel (6) aufweist, zwischengeschaltet ist, **dadurch gekennzeichnet, daß** die Signalverarbeitungsmittel (6) einen Schalter (12) aufweisen, mit dem ein weiterer Schwingkreis (12) zugeschaltet werden kann.

2. TV-Umsetzer mit einem Eingangsumsetzer (1) und einem Ausgangsumsetzer (2), denen eine Zwischenfrequenzeinheit (3), die zumindest einen Phasenregelkreis (5) und Signalverarbeitungsmittel (6) aufweist, zwischengeschaltet ist, **dadurch gekennzeichnet, daß** die Signalverarbeitungsmittel (6) einen Schalter (11) aufweisen, mit dem auf einen weiteren Schwingkreis (13) umgeschaltet werden kann.

3. TV-Umsetzer nach Anspruch 1 oder 2, **dadurch gekennzeichnet, daß** der Schalter (11) ein elektronischer Schalter ist.

4. TV-Umsetzer nach Anspruch 1, 2 oder 3, **dadurch gekennzeichnet, daß** der Phasenregelkreis (5) mit einem Monoflop (13) verschaltet ist, wobei das Monoflop (13) den Schalter (11) in Abhängigkeit des Ausgangssignals (Locked-Signales) des Phasenregelkreises (5) betätigt.

5. TV-Umsetzer nach einem der vorhergehenden Ansprüche, **dadurch gekennzeichnet, daß** Mittel zur Erzeugung einer Referenzfrequenz (REF) für den Phasenregelkreis (5) vorgesehen sind.
